# EUROPEAN PATENT APPLICATION

(11) **EP 4 376 009 A1**
(43) Date of publication of application: **29.05.2024**
(21) Application number: 23210502.3
(22) Date of filing: 17.11.2023
(51) Int. Cl.: G11C 11/56, G11C 13/00, H10N 70/20

(54) **ENERGY EFFICIENT MEMRISTOR BASED ON ORTHORHOMBIC TIN SELENIDE (SNSE) MICROMETRIC FLAKES, METHOD OF OBTAINING THEREOF AND APPLICATIONS THEREOF**

(30) Priority: 28.11.2022 RO 202200776
(71) Applicant: Institutul National de Cercetare-Dezvoltare pentru Fizica Materialelor (INCDFM), Magurele, Ilfov (RO)
(72) Inventor: BURUIANA, Angel-Theodor, Navodari, Constanta (RO); BOCIRNEA, Elena Amelia, Craiova, Dolj (RO); KUNCSER, Andrei, Bucuresti (RO); TITE, Teddy, 051511 Bucuresti (RO); MATEI, Elena, 077125 Magurele, Ilfov (RO); MIHAI, Claudia, Ciochina, Ialomita (RO); VELEA, Alin, Bucuresti (RO); GALCA, Aurelian-Catalin, Magurele, Ilfov (RO)
(74) Representative: Dobrescu, Teodora Valentina

(57) **Abstract**

The present application relates to an energy-efficient memristor based on orthorhombic tin selenide monocrystalline micrometric flakes with a low threshold voltage for a maximum operating current in the order of tens to hundreds of microamperes that can be used in artificial neural networks (neuromorphic networks) requiring shorter processing times, low energy consumption, and information processing similar to the human brain. Moreover, this memristor demonstrates a gradual switching of resistance after switching to the state of low electrical resistance, by the application of positive DC sweeps with increasing voltage. Additionally, this application discloses a method for obtaining this energy-efficient memristor based on tin selenide that is easy to implement in the industry and with reduced fabrication costs. This application also reveals a method for using the disclosed memristor.

The applications of these memristors are numerous, the most important being in neuromorphic computing systems, artificial neural networks, and loT devices.

## Description

### Field of the Invention

This invention relates to an energy-efficient memristor based on micrometric orthorhombic tin selenide (SnSe) flakes, to a method of obtaining the same, and to its applications in non-volatile storage devices, neuromorphic computing, and loT (Internet of Things) devices. Additionally, a method for using the memristor from this patent application is disclosed.

### State of the Art

In recent decades, the way we work, live, and interact has been fundamentally changed due to the exponential growth of electronics and information processing capacity. The efficiency of information processing is considered a new benchmark, in addition to processing capacity, which is of great importance in fields with a large volume of data such as loT (Internet of Things) devices and autonomous vehicles. To further improve the efficiency of information processing, electronic devices must have a low manufacturing cost, exhibit scalability in terms of speed and processing efficiency, and have low energy consumption. Due to the physical limitations and very high manufacturing costs, the sub-10-nanometer technology nodes of traditional transistors (at the limit of Moore's Law) cannot afford cost-effective and sustainable scaling, thus requiring new electronic high-efficiency processing devices to meet the demands of ever-growing information technology markets [Y. Li et al. J.Phys D: Appl. Phys. 51 (2018)].

Artificial neural networks, an information processing technology inspired by the biological model, had an important influence in science, technology, and our way of life. However, even the most advanced artificial neural networks run on computers built using von Neumann architecture, which results in long processing times and high energy consumption. Unlike the von Neumann architecture, which uses an information processing unit and a storage unit, neuromorphic computing systems implement memory and information processing in a way similar to the human brain. By overcoming the limitation of the von Neumann architecture, neuromorphic networks are promising, particularly for processing large volumes of information and training neural networks [L. Sun et al. Advanced Intelligent Systems 2 (2020)].

A device that can be used in a neuromorphic network is a memristor. The memristor is a two-terminal device that can store information in different levels of electrical resistance (having two or more states) that can be obtained by remembering previously applied electrical voltages, allowing it to mimic a biological synapse in the neural network of the human brain.

Group IV monochalcogenides are two-dimensional (2D) layered materials with multiple metastable states that can have switching properties. These materials have a structure similar to phosphorene, but unlike it, are formed from two elements with different electronegativities, breaking the inversion symmetry of the monolayers. This property can lead to new and interesting properties and new physical phenomena. Group IV monochalcogenides have a tunable bandgap as well as anisotropic optoelectronic and mechanical properties, while being more stable against oxidation than phosphorene [L. Yang et al. Nanotechnology 29 215703 (2018)].

As the information processing requirements in electronic devices are exponentially increasing, there is a need for new devices with low processing times and low energy consumption that process information similar to the human brain and are economically viable (low fabrication and operating costs).

**The purpose of the invention** is to provide an energy-efficient memristor based on monocrystalline orthorhombic tin selenide micrometric flakes, with a low threshold voltage (in the order of volts) for a maximum operating current in the range of tens to hundreds of microamperes, and with a gradual change in electrical resistance which aims to eliminate the disadvantages of existing devices from the state of the art. Another purpose of this invention is to provide a method for obtaining this energy-efficient memristor based on tin selenide.

A further purpose of the invention is the use of these energy-efficient memristors, which exhibit a gradual change in electrical resistance, in neuromorphic computing systems, in artificial neural networks and in loT devices (Internet of Things).

### Brief Description of the Drawings

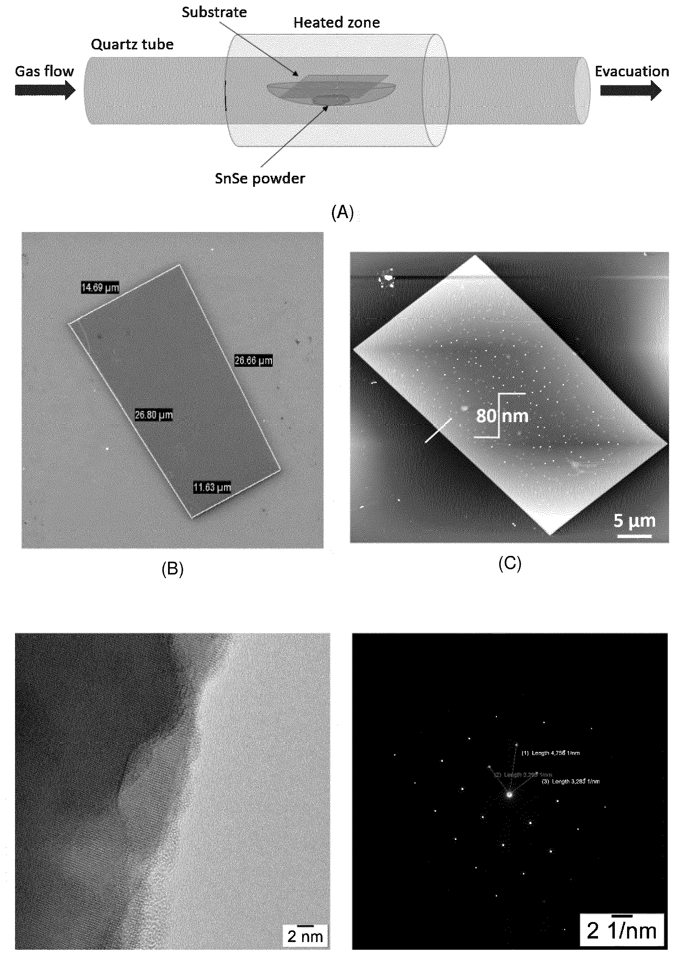

FIG. 1 illustrates the schematic of the deposition setup and characterization of orthorhombic tin selenide (SnSe) flakes that can be used for obtaining an energy-efficient memristor in accordance with the present invention.
FIG. 1(A) presents the schematic of the setup used in the Physical Vapor Transport (PVT) deposition technique employed in the synthesis of tin selenide flakes.
FIG. 1(B) shows a scanning electron microscopy (SEM) image of a tin selenide flake deposited on a Si\SiO2 (300 nm) substrate, in accordance with with at least one example.
FIG. 1(C) displays the thickness of the flakes measured using atomic force microscopy (AFM).
FIG. 1(D) represents a high-resolution image of the flake obtained by transmission electron microscopy (TEM) technique.
FIG. 1(E) shows the electron diffraction in this area, performed along the [1 0 0] axis, confirming the monocrystalline orthorhombic structure (b = 4.206 Å and c = 4.396 Å).
FIG. 1(F) represents the elemental mapping images obtained by energy dispersive X-ray spectroscopy (EDX) demonstrating that the atoms of Sn and Se are uniformly distributed throughout the flake.
FIG. 2(A) illustrates the non-volatile switching of the memristor following the application of an electrical voltage. A scanning electron microscopy image of a device is included in the inset.
FIG. 2(B) shows the gradual switching of the SnSe memristor using DC sweeps with increasing voltage.

### Brief Description of the Invention

The present invention addresses and eliminates the aforementioned disadvantages, as well as other drawbacks found in the state of the art.

A primary objective of the present invention is to provide an energy-efficient memristor based on monocrystalline orthorhombic tin selenide micrometric flakes, with a low threshold voltage (in the order of volts) for a maximum operating current ranging from tens to hundreds of microamperes. This memristor offers a gradual switching of electrical resistance and can be used in artificial neural networks (neuromorphic networks), requiring shorter processing times, low energy consumption, and processes information in a manner similar to the human brain. Another objective of this invention is to provide a method for obtaining this energy-efficient memristor based on orthorhombic tin selenide, which is easy to implement industrially with reduced fabrication costs.

Yet another objective of the invention is the use of these energy-efficient, multi-state (gradual switching) memristors, in neuromorphic computing systems, artificial neural networks, and loT devices.

A further objective of the present invention is to provide a method for using the memristor disclosed herein, which has two stages:
- a first stage of surpassing the threshold voltage for setting the memristor;
- a second stage where gradual switching is achieved by applying increasing electrical voltages with a certain gradient.

### Definition of Terms Used in This Description

loT (Internet of Things) devices refer to a network of interconnected physical objects that collect, process, and exchange data with integrated systems. These devices can range from environmental sensors and health monitoring devices to industrial equipment and autonomous vehicles, all designed to operate within an interconnected digital ecosystem.

A memristor is a two-terminal device that can store information in different levels of electrical resistance (having two or more states) that can be achieved by remembering previously applied electrical voltages, allowing it to mimic a biological synapse in the human brain's neural network.

The term "Group IV monochalcogenides" refers to compounds of the form GeS, GeSe, SnS, and SnSe.

SnSe - tin selenide.

The term "Gradual Resistance Switching" refers to the ability to change the electrical resistance of the device in a controlled and progressive manner, rather than just between two discrete states (high and low resistance). This expression is equivalent to the term "multiple resistance states."

The term "DC sweeps" refers to a testing procedure where a continuous variation (sweep) of direct voltage (DC - Direct Current) is applied through an electronic device to observe its response (the current passing through it) to different voltage values.

### Description of the Invention

The invention will be described in detail below.

In a **first example,** the invention refers to an energy-efficient memristor based on SnSe, which consists of a orthorhombic SnSe monocrystalline micrometric flake, with the concentration of Se expressed in atomic percentages ranging from 45 to 55% and the concentration of Sn expressed in atomic percentages ranging from 45 to 55%. The flake is placed between two planar metal contacts; **where** the setting voltage of the memristor is between 2 and 3.5 V, preferably 2.5 V, with an operational current ranging from 10⁻⁹ A to 10⁻⁴ A; and **which** exhibits a gradual change in electrical resistance (multiple resistance states).

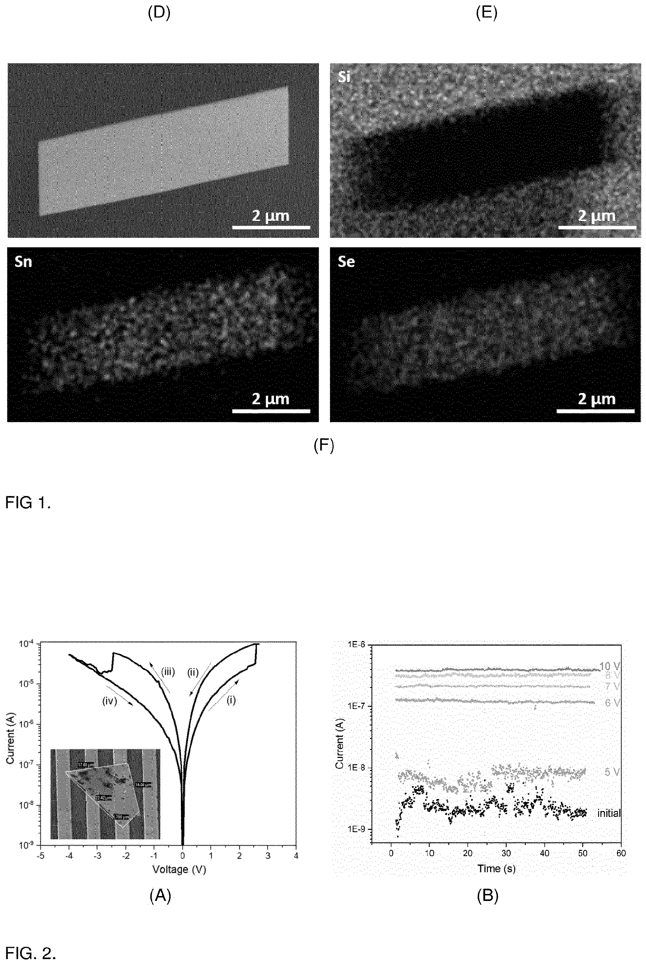

The switching mechanism between memory states with different electrical resistance is the migration of defects towards the edges of the orthorhombic SnSe monocrystalline micrometric flake. Non-volatile switching of the memristor has been observed following the application of an electrical voltage. Initially, the memristor is in a high electrical resistance state. By applying a positive electrical voltage (Fig. 2 (A) (i)) the current slowly increases until the threshold voltage (SET voltage) is reached, which results in an extremely rapid increase in current. The memristor is now in a low electrical resistance state and remains in this state after reducing the voltage to 0 V (ii). Applying a negative electrical voltage (iii), after exceeding the threshold voltage (RESET voltage), the memristor changes its state to a high electrical resistance state, remaining so after reducing the electrical voltage to 0 V (iv). Atomic vacancies acting as dopants migrate towards the edges of the flake when an electric field is applied. This migration changes the energy of the Schottky barriers at the contact between the tin selenide micrometric flake and the metal electrodes and is the cause of the resistance change in the memristor. Surprisingly, in the low electrical resistance state, another mode of operation of the memristor from the present invention was observed, where switching is gradual by applying DC sweeps with increasing voltage. After each DC sweep, the current can be measured by applying a voltage of 1 V. Multiple states of electrical resistance are achieved, each resistance level being stable during the measurement. Due to the existence of these two operation modes - non-volatile switching and gradual resistance switching in the low electrical resistance state, which is also non-volatile - the memristor from the present patent application operates extremely efficiently as an artificial synapse, facilitating parallel information processing, similar to the human brain.

After the memristor has switched to a low electrical resistance state by applying a DC sweep up to a voltage higher than the threshold voltage (for example, up to 3 V, the threshold voltage having a preferable value of 2.5 V), if further DC sweeps with increasing voltages (for example, 5 V, 6 V, 7 V, 8 V, or 10 V) are applied, the resistance of the memristor gradually decreases to values that are stable during the measurement.

Gradual switching is achieved by applying DC sweeps after the memristor has switched to the low electrical resistance state (i.e., after the threshold voltage). In this state, without resetting the memristor (resetting is done by applying a negative DC sweep with a voltage higher than the threshold voltage), further positive sweeps with increasing voltage are applied (we used 5V, 6V, 7V, 8V, 10V). There is no other threshold voltage, only a rearrangement of the defects leading to a further reduction in device resistance.

Following various experimental determinations, it was found that the atoms of Sn and Se are uniformly distributed throughout the entire flake, while EDX quantification demonstrates that the atomic percentages of Sn are between 45 - 55% and those of Se between 45 - 55%. The presented morphology and structure of the tin selenide flakes indicate an orthorhombic crystalline structure, while the reported atomic percentage suggests an equiatomic composition with possible slightly different local configurations.

In orthorhombic tin selenide, the atoms are arranged in adjacent double layers of Sn and Se that are held together by weak van der Waals interactions [W.J. Baumgardner et al. J. Am. Chem. Soc. 132 (2010)].

In a particularly preferred embodiment, the orthorhombic SnSe monocrystalline micrometric flake has a trapezoidal shape. The flakes have a rectangular or trapezoidal shape, whose lateral size ranges from 5 - 60 micrometers and a thickness from 70 to 150 nanometers. In a particularly preferred embodiment, the flakes have a lateral size of 15 micrometers and a thickness of 70 nanometers.

In a particularly preferred embodiment, the orthorhombic SnSe monocrystalline micrometric flake has a rectangular shape.

In another embodiment of the invention, the orthorhombic SnSe monocrystalline micrometric flake has a lateral size ranging from 5 to 60 micrometers and a thickness ranging from 70 to 150 nanometers.

In an even more preferred embodiment of the invention, the orthorhombic SnSe monocrystalline micrometric flake has a lateral size of 15 micrometers and a thickness preferably ranging from 70 to 80 nanometers.

In an even more preferred embodiment of the invention, the orthorhombic SnSe monocrystalline micrometric flake has a lateral size ranging from 5 to 25 micrometers and a thickness preferably ranging from 70 to 80 nanometers.

In another embodiment, the invention provides a method for obtaining an energy-efficient memristor based on tin selenide, which includes the following steps:
a) Sublimation of the SnSe precursor powder where the concentration of Se expressed in atomic percentages is in the range of 45 to 55% and the concentration of Sn expressed in atomic percentages is in the range of 45 to 55%;
b) Formation of monocrystalline orthorhombic SnSe micrometric flakes by deposition of SnSe vapors from the previous step on a chosen support substrate, preferably among Si\SiO₂, quartz, or sapphire, at a temperature ranging from 700 to 950°C, in a chamber through which an inert gas flow passes where the flow rate of inert gas is in the range of 30 to 100 sccm (standard cubic centimeters per minute), in a time range from 1 to 10 minutes, at atmospheric pressure;
c) Transfer of the monocrystalline orthorhombic SnSe micrometric flakes obtained in the previous step from the support substrate to the metal contacts.

In an even more preferred embodiment, the temperature in step b) at which the monocrystalline orthorhombic SnSe micrometric flakes are deposited on the support substrate is 820°C, the flow rate of inert gas is preferably in the range of 80 to 100 sccm over a time interval from 2 to 5 minutes. In this case, predominantly monocrystalline orthorhombic SnSe micrometric flakes with lateral dimensions ranging from 5 to 60 micrometers, preferably between 5 to 25 micrometers, and a thickness ranging from 70 to 150 nanometers are obtained.

Depending on the modification of the parameters of the obtaining method, namely the change of the temperature, the gas flow, and the time interval, monocrystalline orthorhombic SnSe micrometric flakes with different sizes will be obtained. These intervals can be reduced to obtain a much narrower distribution of monocrystalline orthorhombic SnSe micrometric flake sizes. For example, at a temperature of 820°C, a flow of 100 sccm, and a deposition time of 2 minutes, SnSe flakes with a thickness of 70 nm and lateral dimensions between 5 and 25 micrometers are obtained.

In another particularly preferred embodiment, the inert gas is preferably selected among N₂, Ar, or a mixture of H₂ and Ar. The inert atmosphere is essential for obtaining monocrystalline orthorhombic SnSe micrometric flakes.

In another preferred embodiment, the transfer of the monocrystalline orthorhombic SnSe micrometric flakes is preferably done with an optical microscope and an adhesive material.

In a particularly preferred embodiment, the adhesive material is preferably selected among PDMS or GelPak.

In yet another embodiment, the invention discloses a method for using an energy-efficient SnSe-based memristor, which has two stages:
- a first stage of surpassing the threshold voltage for setting the memristor;
- a second stage where gradual switching is achieved by applying increasing electrical voltages with a certain gradient.

As previously stated herein, in a preferred embodiment, gradual switching is done by applying an increasing electrical voltage with a gradient of 1 V. Another preferred embodiment is where the switching threshold is 2.5 V.

The advantage of this method over those existing in the state of the art is that it is easy to implement industrially and has reduced fabrication costs. The method of the invention does not require complex processes and very high temperatures. In addition, it does not require advanced processes of electron lithography or the use of photoresists that could contaminate the memristor material.

Moreover, the chemical vapor deposition method has the advantages of a fast process and allows obtaining high-quality flakes if the deposition parameters are optimally adjusted.

### Specific embodiment:

In the following, a specific embodiment will be given which should not be considered in any way as limiting.

For the fabrication of energy-efficient tin selenide memristors, a two-step method is used, which is technically easy to carry out, simple to implement, and cost-effective.

The first stage involves obtaining orthorhombic SnSe monocrystalline micrometric flakes via the chemical vapor deposition technique. A quartz tube, preferably having a diameter of 2.5 cm or 5 cm but not limited to these values, and a length between 1600 and 2000 mm, which can be sealed tightly at the ends, is introduced into a tubular furnace. In the quartz tube, a concave container, preferably in the form of a boat, is placed within another quartz tube smaller in diameter than the previous tube and with a length between 600 and 1000 mm. This concave container, which can preferably be made of quartz or alumina but is not limited to these materials, holds the high-purity precursor SnSe powder (with Se concentration in atomic percentage ranging from 45 to 55% and Sn concentration in atomic percentage from 45 to 55%). The amount of powder ranges from 3 to 5 mg, preferably 3 mg, and is linearly placed in the center of the concave container. During this stage, the concave container, or boat, is positioned downstream from the heating zone, at a short distance, so until the furnace reaches the maximum temperature, the concave container remains at a much lower temperature. A support substrate, which can be selected from but is not limited to Si\SiO₂, quartz, or sapphire, having a width between 18 and 20 mm and a length between 36 and 40 mm, is positioned above the concave container, either face down or up on the boat, preferably face down, over the precursor SnSe powder at a short distance (between 5 and 10 mm, preferably 5 mm), nearly fully covering the concave container (-80%, with 3 to 5 mm of free space left both downstream and upstream). Then, the quartz tube undergoes a sequence of three vacuum and purge cycles with a high flow rate of inert gas to drastically reduce the oxygen concentration in the tube. The gas can be preferably selected from Ar, N₂, or a mixture of Ar and H₂, of high purity (5N). After the third purge, the flow rate of the inert gas is reduced to a value between 30 and 100 sccm, preferably 100 sccm, and is maintained constant during the furnace heating. The furnace is heated according to the following program: (i) from 20 ºC to 720ºC in 20 minutes, (ii) from 720ºC to 925ºC in 25 minutes, (iii) maintain for 1 minute at 925ºC. When the furnace reaches the necessary temperature for the sublimation of SnSe powder, which can be between 700 - 950°C, preferably 925°C, the preheated powder, at a temperature between 400 - 500°C, is quickly moved to the center of the heating zone by moving the furnace. Subsequently, the furnace heating is programmed as follows: (i) 1 minute decrease from 925ºC to 850ºC, (ii) 1 minute decrease from 850ºC to 820ºC. The sublimation of the SnSe powder occurs, and the inert gas flow deposits the SnSe vapors on the support substrate in a manner that favors the formation of SnSe monocrystals. A deposition period, which can be between 1 and 10 minutes, preferably between 2 and 5 minutes, is applied. To conclude the deposition process, the furnace is turned off, and the flow of inert gas through the quartz tube is increased for rapid cooling and removal of vapors from the surface area of the support substrate. The furnace is then moved back to its initial position, and the concave container, or boat, is outside the heating zone.

The second stage involves transferring the orthorhombic SnSe monocrystalline micrometric flake, from the support substrate on which it was formed, onto the metallic contacts of the device, obtained by photolithography. The contacts have a thickness ranging from 80 nm to 120 nm and a distance between them ranging from 2 micrometers to 5 micrometers.

First, the location of the flake to be transferred is identified on the substrate under the optical microscope. An adhesive material is used for detaching the selected flakes. This can be chosen from, but is not limited to, PDMS or GelPak. The adhesive material is held for 3 - 5 seconds above a beaker of boiling deionized water to allow the water to condense on its surface. It is then applied to the substrate in the area of the flake and quickly detached, with the orthorhombic SnSe monocrystalline micrometric flake remaining attached to it. Pulled by capillary force, the flakes detach from the substrate and remain on the adhesive material, ready to be transferred onto the T\Au contacts. Under the microscope, the adhesive material, preferably PDMS or GelPak, is positioned so that the flake is above the electrodes, brought into contact by light pressing, and the adhesive material is very slowly detached, with the flake remaining on the electrodes.

The chemical vapor deposition method has the advantages of being a rapid process and allows obtainig of high-quality flakes if the deposition parameters are optimally adjusted.

A comparative example is provided which illustrates the difference between the operating parameters of the memristor comprising of orthorhombic SnSe monocrystalline micrometric flakes and the operating parameters of memristors based on other materials.

Unlike other types of lateral memristors from the state of art based on the same switching mechanism, defect migration, the memristor from this application has a threshold voltage an order of magnitude lower (2.5 V) for a comparable operating current (10⁻⁴ A), which translates into much lower energy consumption. This is due to the anisotropic electrical conductivity of SnSe, with a maximum conductivity along the b and c directions, and a conductivity 10 times lower along the a-axis, also suggesting that lateral memristors are preferred compared to vertical devices. Moreover, this defect migration switching mechanism is preferred over other mechanisms because it does not require structural modifications of the material as in the case of phase change switching nor the migration of metallic atoms/ions within the material, which over time will segregate and deteriorate the functioning of the memristor, as in the case of the filamentary mechanism.

| Memristor | Switching mechanism | SET voltage [V] | Operation current [A] | Endurance [Cycle] | Retention [s] | Reference |
|---|---|---|---|---|---|---|
| Au-MoS2-Au | Defect migration | 80.0 | 10⁻⁴ | 475 | 9 × 10⁴ | V.K. Sangwan, et al. D. Nature Nanotech. 10 (2015) |
| Ti/Au-MoS₂-Ti/Au | Defect migration | 50.3 | 10⁻⁴ | N/A | N/A | Da Li et al. ACS Nano 12 (2018) |
| Au-MoS₂-Au | Phase transition | 3.0 | 10⁻⁵ | 1000 | 7 × 10³ | X. Zhu et al. Nature Mater 18 (2019) |
| Ti-TaS₂-Ti | Phase transition | 3.0 | 10⁻³ | N/A | N/A | M. Yoshida et al. Sci. Adv. 1 (2015) |
| Ag-MoS₂-Pt | Filament formation | 2.0 | 10⁻⁵ | N/A | N/A | S. Yin et al. Phys. Status Solidi A 216 (2019) |
| Ag-SnOₓ/SnSe-Ni/Au | Filament formation | 0.4 | 10⁻⁵ | 4000 | 10 | J. Guo et al. Matter 2 (2020) |
| Cr/Au-NbOx/NbSe₂-Cr/Au | Filament formation | 1.0 | 10⁻⁴ | 20 | 3000 | J. Eun Kim et al. Appl. Sci. 10 (2020) |

A comparison between the memristor proposed in this patent application and similar devices found in the state of art, based on transition metal dichalcogenides or group IV monochalcogenides, is presented in the table above. In the case of the defect-mediated switching mechanism, as with the memristor from this patent application, the device's resistance changes as defects migrate towards the crystallite boundaries, forming a low-resistance channel [Vinod K. Sangwan et al., Nature 554 (2018)]. The accumulation of chalcogen vacancies near the crystallite boundaries induces changes in conductance during the setting and resetting processes and causes memristive switching. Atomic vacancies acting as dopants migrate through the crystallite boundaries under an external electric field. Such migration dynamically modifies the Schottky barriers between the flake and the metallic electrodes and causes changes in the resistance of memristors. The switching voltage has a very high value of 80 V in this case. Two switching modes were also found in few-layer thick MoS₂ memristors with a lateral device architecture and Ti/Au electrodes [Da Li et al., ACS Nano 12 (2018)], these being the rectification-mediated modes and conductance-mediated modes, which were attributed to the modulation of MoS₂/Ti Schottky barriers and the redistribution of ionic vacancies in MoS₂. These memristors also have a high threshold voltage of 50 V. Recently, Xiaojian Zhu et al. [Xiaojian Zhu et al., Nature Mater. 18 (2019)] reported a reversible modulation of electrical resistance in MoS₂ films where the switching mechanism is given by the phase transition of Mo_{S2} by controlling the migration of Li⁺ ions with the applied electric field. The device has a setting voltage of 3 V, which is an order of magnitude smaller than the threshold voltage of defect migration-based memristors and an operational current of 10⁻⁵ A. This switching mechanism is also present in 1T-type thin crystals of tantalum disulfide, where reduced thickness is important for achieving such non-volatile electrical switching behavior [Masaro Yoshida et al., Sci. Adv. 1 (2015)]. Another switching mechanism is the formation of either a metallic filament or one made from oxygen vacancies, reported in MoS2, SnSe, and NbSe₂ devices [Siqi Yin et al., Phys Status Solidi A 216 (2019), Juan Guo et al., Matter. 2 (2020), Ji Eun Kim et al., Appl. Sci. 10 (2020)]. Unlike other types of switching, these have a low threshold voltage, ranging from 0.4 to 2 V.

Unlike memristors revealed in the current state of art, the memristor in this application exhibits non-volatile switching and gradual switching, making it extremely efficient as an artificial synapse that mimics a human brain synapse in neural networks. Furthermore, the memristor in this application has a low threshold voltage of about 2.5 V, making it extremely cost-effective.

### Industrial Applications

The industrial applications for the memristor in this application are numerous. Among these, the most important are related to its use in:
- Non-volatile storage devices such as SSDs, to improve energy efficiency. Due to its efficient/rapid switching mechanism, the memristor can successfully replace flash memory or DRAM technologies in certain applications;
- Neuromorphic computing, as the memristor can function as an artificial synapse, due to its multiple levels of electrical resistance (gradual switching), facilitating parallel information processing. This is essential for the efficient implementation of machine learning algorithms and neural networks;
- In loT devices, energy efficiency is very important. The memristor can be integrated into sensors and monitoring devices to improve battery life, increase processing speed, and reduce the need for maintenance.

## Claims

1. An energy-efficient memristor based on SnSe **characterized in that** it:
- is composed of a orthorhombic SnSe monocrystalline micrometric flake with the concentration of Se expressed in atomic percentages ranging from 45 to 55% and the concentration of Sn expressed in atomic percentages ranging from 45 to 55%, the flake being placed between two metallic contacts;
and **in that** the setting voltage of the memristor that ranges from 2 to 3.5 V, preferably 2.5 V with an operational current ranging from 10⁻⁹ A to 10⁻⁴ A;

2. Energy-efficient memristor based on SnSe according to claim 1 configured such that it exhibits multiple resistance states upon successive application of gradual voltages.

3. Energy-efficient memristor based on SnSe according to any of the preceding claims wherein the orthorhombic SnSe monocrystalline micrometric flake has a trapezoidal or rectangular shape.

4. Energy-efficient memristor based on SnSe according to any of the preceding claims where the orthorhombic SnSe monocrystalline flake has:
- a lateral dimension ranging from 5 to 60 micrometers, preferably between 5 and 25 micrometers, and more preferably between 5 and 15 micrometers; and
- a thickness ranging from 70 to 150 nanometers, preferably between 70 and 80 nanometers.

5. A method for obtaining the SnSe-based memristor from any of the preceding claims that comprises the following steps:
a. Sublimation of the precursor SnSe powder where the concentration of Se expressed in atomic percentages is between 45 and 55% and the concentration of Sn expressed in atomic percentages is between 45 and 55%;
b. Formation of orthorhombic SnSe micrometric flakes by the deposition of SnSe vapors from the previous step onto a support substrate chosen preferably from Si\SiO₂, quartz, or sapphire, at a temperature ranging from 700 to 950°C, preferably 820°C, in an enclosure through which an inert gas flow passes, wherein the flow rate of the inert gas is between 30 and 100 sccm, preferably between 80 and 100 sccm, over a time interval ranging from 1 to 10 minutes, preferably from 2 to 5 minutes at atmospheric pressure;
c. Transfer of the obtained orthorhombic micrometric flakes from the previous step from the support substrate onto the metallic contacts.

6. Method according to claim 5 where the inert gas is preferably selected from N₂, Ar, or a mixture of H₂ and Ar.

7. Method according to claim 5 where the transfer of flakes is done, preferably, with an optical microscope and an adhesive material selected preferably from PDMS or GelPak.

8. Method of using the memristor from claims 1 - 4 or the one obtained from the methods of claims 5 - 7 in non-volatile storage devices, neuromorphic computing, and loT devices.

9. Method of using an energy-efficient memristor based on orthorhombic SnSe from claims 1 to 4 or the one obtained from the methods of claims 5 to 7 which has two stages:
- a first stage of surpassing the threshold voltage of the memristor;
- a second stage where gradual switching is achieved by applying increasing voltages with a certain gradient.

10. Method of use according to claim 9 where the gradient is 1V.

11. Method of use according to claim 9 where the voltage threshold is 2.5 V.
